(19) Europäisches Patentamt
European Patent Office
Office européen des brevets

(11) **EP 2 524 397 B1**

(12) **FASCICULE DE BREVET EUROPEEN**

(45) Date de publication et mention
de la délivrance du brevet:
**11.12.2013 Bulletin 2013/50**

(21) Numéro de dépôt: **11703914.9**

(22) Date de dépôt: **10.01.2011**

(51) Int Cl.:
*H01L 31/042* *(2006.01)*     *H01L 31/02* *(2006.01)*

(86) Numéro de dépôt international:
**PCT/FR2011/000011**

(87) Numéro de publication internationale:
**WO 2011/086295 (21.07.2011 Gazette 2011/29)**

(54) **SYSTÈME DE GESTION ET DE COMMANDE DE PANNEAUX PHOTOVOLTAÏQUES**

SYSTEM ZUR VERWALTUNG UND STEUERUNG VON PV-MODULEN

SYSTEM FOR MANAGING AND CONTROLLING PHOTOVOLTAIC PANELS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.01.2010 FR 1000108**

(43) Date de publication de la demande:
**21.11.2012 Bulletin 2012/47**

(73) Titulaires:
• **Arnaud, Thierry**
  **74330 Poisy (FR)**
• **Wellig, Armin**
  **1242 Satigny (CH)**
• **Pozsgay, Andras**
  **74130 Contamine Sur Arve (FR)**

(72) Inventeur: **POZSGAY, Andras**
  **F-74130 Contamine Sur Arve (FR)**

(74) Mandataire: **Myon, Gérard Jean-Pierre**
  **Cabinet Lavoix**
  **62, Rue de Bonnel**
  **69448 Lyon Cedex 03 (FR)**

(56) Documents cités:
**EP-A2- 2 141 746      WO-A1-01/80321
WO-A1-2006/125664   US-A1- 2009 161 394**

## Description

### Domaine technique de l'invention

L'invention est relative à la gestion d'un parc de panneaux photovoltaïques.

### État de la technique

Un panneau photovoltaïque classique comporte plusieurs associations parallèle/série de cellules photovoltaïques et développe à ses bornes une tension continue d'une quarantaine de volts sous des conditions d'éclairement nominales. Dans une installation minimale, on connecte en série une dizaine de panneaux pour produire une tension continue, de l'ordre de 400 V, qui est exploitable avec un bon rendement par un onduleur pour transférer l'énergie produite sur le réseau.

Un avantage de la connexion en série des panneaux est que la connectique est réduite à deux bornes de connexion par panneau, plus une borne de terre, ce qui facilite l'installation. Les panneaux sont ainsi équipés de boîtiers de jonction normalisés comportant les bornes requises.

Néanmoins, la connexion en série peut présenter un certain nombre de problèmes.

Le courant produit par une chaîne série de panneaux est déterminé par le maillon le plus faible, c'est-à-dire le panneau générant le courant le plus faible. Ce panneau peut simplement être un panneau se trouvant à l'ombre. Dans une telle situation, il faut établir un chemin court-circuitant le panneau, de sorte que les panneaux fonctionnant dans des conditions normales puissent débiter leur courant nominal. Pour cela, les panneaux sont équipés de diodes dites de « bypass », connectées entre les bornes du panneau, dans le sens du courant, qui s'avère être le sens bloqué des diodes par rapport à la tension générée par le panneau. Lorsqu'un panneau ne génère plus de tension, le courant de la chaîne passe par ses diodes de « bypass ».

Toutefois, lorsqu'un panneau est partiellement à l'ombre, il produira une tension inférieure à sa tension nominale, mais suffisante pour éviter la mise en fonction des diodes de « bypass ».

Pour gérer une telle situation de manière plus intelligente, on a prévu d'équiper chaque panneau photovoltaïque d'un module de commande alimenté électriquement par le panneau, comme cela est décrit dans les demandes de brevet WO 01/80321 A, EP 2 141 746 A2 et plus particulièrement dans le brevet US7602080.

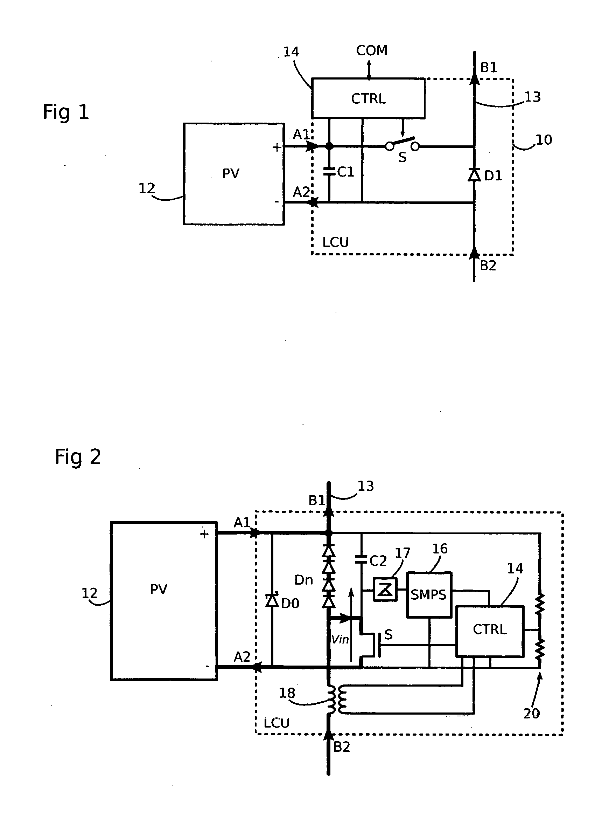

La figure 1 représente schématiquement un module de commande locale 10 (LCU) associé à un panneau 12, tel que décrit dans le brevet susmentionné. Le module de commande LCU est relié au panneau 12 par deux bornes de connexion A1 et A2, la borne A1 étant reliée au « + » du panneau, et la borne A2 au « - ». Le module comprend deux bornes B1 et B2 de mise en série par un conducteur unique 13 à des modules homologues.

Une diode de « bypass » D1 a sa cathode reliée à la borne B1 et son anode reliée à la borne B2. Le sens du courant série dans le conducteur 13 est ainsi de la borne B2 vers la borne B1. Un commutateur S, commandé par un circuit 14, est connecté entre les bornes A1 et B1. Un condensateur C1 est connecté entre les bornes A1 et A2. Le circuit de commande 14 est alimenté par le panneau 12, entre les bornes A1 et A2. Il communique avec une centrale commune située au niveau de l'onduleur par une liaison COM. Cette liaison, pour éviter de multiplier le nombre de connexions entre panneaux, peut se faire par courant porteur sur le conducteur de liaison série ou par communication sans fil.

L'objectif de ce système de gestion est de commander en mode haché le commutateur S d'un module associé à un panneau faiblement éclairé pour optimiser le transfert d'énergie.

Comme on l'a indiqué, les modules de commande LCU sont alimentés par le panneau 12 associé. Si la production électrique du panneau est insuffisante, le module ne fonctionne plus. Dans ce cas, le module est incapable de communiquer avec la centrale de gestion, notamment pour indiquer l'état hors service, permanent ou temporaire, du panneau.

Le système décrit dans le brevet susmentionné utilise des moyens complexes de communication entre les modules et la centrale de gestion. Chaque module doit intégrer un microcontrôleur et un modem par courant porteur ou de communication sans fil. Ces moyens sont trop coûteux pour des installations bas de gamme auxquelles on veut intégrer néanmoins certaines fonctions de base.

Un parc de panneaux photovoltaïques présente un danger d'électrocution lors du montage. En effet, un panneau éclairé, même déconnecté, commence à produire de l'électricité. A mesure que l'on connecte les panneaux en série, la différence de potentiel présente entre les bornes extrêmes des panneaux montés augmente, cette différence de potentiel atteignant de l'ordre de 400 V au moment où il faut connecter le dernier panneau.

Dans les parcs actuels, il est difficile de localiser l'emplacement d'une coupure accidentelle du conducteur de liaison série. En effet, la coupure du conducteur série annule le courant dans celui-ci. L'annulation du courant est vue par tous les modules des panneaux en même temps, de sorte qu'un module, même doté d'intelligence, ne peut pas déterminer que la coupure a lieu à son niveau pour la signaler.

### Résumé de l'invention

L'invention concerne un module de commande locale d'un panneau photovoltaïque selon la revendication 1.

Ainsi, on peut souhaiter qu'un module de commande locale d'un panneau photovoltaïque puisse être alimenté électriquement même si le panneau ne produit pas d'électricité, et cela sans utiliser de liaisons autres que le conducteur de liaison série des panneaux.

Pour satisfaire ce besoin, on prévoit un module de commande locale d'un panneau photovoltaïque comprenant des première et seconde bornes de mise en série avec des modules homologues par un conducteur unique, et des moyens pour alimenter le module en électricité à partir du courant circulant dans le conducteur unique.

Un mode de réalisation de centrale de gestion d'un ensemble de modules de ce type comprend un capteur pour mesurer le courant circulant dans le conducteur unique et des moyens pour injecter dans le conducteur unique un courant suffisant pour alimenter les modules lorsque le courant mesuré est inférieur à un seuil.

On peut souhaiter par ailleurs que le module embarque une intelligence minimale, notamment pour commander un dispositif de sécurité limitant le risque d'électrocution, sans pour autant prévoir des moyens de communication complexes.

Pour satisfaire ce besoin, on prévoit un module de commande locale d'un panneau photovoltaïque comprenant des première et seconde bornes de mise en série par un conducteur unique avec des modules homologues ; une première borne de connexion du panneau photovoltaïque, reliée à la première borne de mise en série ; un commutateur relié entre la seconde borne de mise en série et une seconde borne de connexion du panneau ; une diode reliée entre les première et seconde bornes de mise en série ; un convertisseur prévu pour alimenter le module à partir de la tension développée par le panneau entre les première et seconde bornes de connexion du panneau ; un capteur pour mesurer le courant circulant dans le conducteur unique ; et des moyens pour fermer le commutateur lorsque le courant circulant dans le conducteur unique dépasse un seuil.

Un mode de réalisation de centrale de gestion d'un ensemble de modules de ce type comprend des moyens pour déterminer une mise sous tension de l'ensemble des modules ; et des moyens pour injecter dans le conducteur unique un courant supérieur au seuil lorsque la mise sous tension est déterminée, d'où il résulte la fermeture des commutateurs des modules associés à des panneaux fournissant de l'électricité.

On souhaite finalement pouvoir localiser de manière simple l'emplacement d'une coupure du conducteur de liaison série des panneaux.

Pour satisfaire ce besoin, on prévoit un module de commande locale d'un panneau photovoltaïque comprenant des première et seconde bornes de mise en série avec des modules homologues par un conducteur unique ; un élément diode permettant la circulation de courant entre les première et seconde bornes de mise en série lorsque le panneau photovoltaïque ne produit pas d'électricité ; une borne de connexion à la terre ; et une source de courant constant connectée entre la borne de connexion à la terre et le conducteur unique.

Un mode de réalisation de centrale de gestion d'un ensemble de modules de ce type comprend des première et seconde bornes d'entrée, de connexion aux extrémités du conducteur unique, l'une des bornes d'entrée étant connectée à la terre ; un capteur pour mesurer le courant circulant dans le conducteur unique ; et des moyens pour, à partir du courant mesuré, localiser le module au niveau duquel se trouve la coupure.

La centrale peut mettre en oeuvre un procédé comprenant les étapes suivantes : détecter la coupure par le fait que le courant dans le conducteur unique chute à une valeur résiduelle inférieure ou égale à la somme des courants des sources de courant constant des modules ; et déterminer le rang du module au niveau duquel se situe la coupure en divisant la valeur résiduelle du courant par la valeur des sources de courant constant.

**Description sommaire des dessins**

D'autres avantages et caractéristiques ressortiront plus clairement de la description qui va suivre de modes particuliers de réalisation donnés à titre d'exemples non limitatifs et illustrés à l'aide des dessins annexés, dans lesquels :

- la figure 1, précédemment décrite, représente un module de commande locale de panneau d'un système de gestion classique d'un parc de panneaux photovoltaïques ;

- la figure 2 représente un mode de réalisation de module de commande locale de panneau qui peut être alimenté en électricité indépendamment de la production électrique du panneau ;

- les figures 3a et 3b représentent deux modes de fonctionnement du module de la figure 2 lorsque le panneau produit de l'électricité ;

- les figures 4a et 4b représentent deux modes de fonctionnement du module de la figure 2 lorsque le panneau ne produit pas de l'électricité ;

- la figure 5 représente un mode de réalisation de système de localisation de coupure du conducteur de liaison en série des panneaux et d'une centrale de gestion adaptée ;

- la figure 6 représente un mode de réalisation de module de commande locale de panneau incorporant de moyens de communication simples, notamment pour commander un dispositif de sécurité limitant les risques d'électrocution ;

- la figure 7 représente une variante du module de la figure 2 ;

- la figure 8 représente une autre variante du module de la figure 7 ; et

- les figures 9a et 9b représentent deux modes de fonctionnement de la variante de la figure 8.

**Description de modes de réalisation préférés de l'invention**

La figure 2 représente schématiquement un mode de réalisation de module de commande locale LCU d'un panneau photovoltaïque 12, qui ne dépend pas de la production d'électricité du panneau pour être alimenté. Le module est alimenté à partir du courant série circulant dans le conducteur 13 de liaison série des panneaux.

Le module, destiné à être intégré dans un boîtier de jonction normalisé, comporte les mêmes bornes A1, A2, B1 et B2 que le module de la figure 1. La borne A1 de connexion du panneau est reliée à la borne B1 de mise en série. Le commutateur S, sous la forme d'un transistor MOS à canal N, à titre d'exemple, est relié entre la borne A2 de connexion du panneau et la borne B2 de mise en série. Au lieu de trouver une seule diode entre les bornes B1 et B2, on a un empilement de diodes Dn formant un élément diode dont le seuil de conduction est supérieur à celui d'une diode. Les cathodes de l'empilement de diodes Dn sont du côté de la borne B1. Une diode D0 est connectée par sa cathode à la borne A1, et par son anode à la borne A2. Cette diode D0 a de préférence un faible seuil de conduction, et peut pour cela être une diode Schottky.

La grille du transistor S est commandée par un circuit 14 qui est alimenté entre le potentiel fourni par un convertisseur 16 et la borne A2. La tension d'alimentation Vin du convertisseur 16 est prélevée aux bornes du transistor S. Ainsi, la tension Vin aux bornes du transistor S est particulièrement faible lorsque le transistor S est fermé. Le transistor S est choisi avec une résistance à l'état passant (Rdson) suffisamment élevée pour que la tension à ses bornes, produite par le courant qui le traverse, puisse alimenter le convertisseur 16. On verra ci-après que l'on parvient à alimenter le convertisseur 16 dans tous les modes de fonctionnement du module.

Le convertisseur 16 est de préférence un élévateur de tension à découpage. Il existe sur le marché des élévateurs de tension pouvant produire en régime établi une tension d'alimentation suffisante à partir de moins de 100 mV, tel que le circuit L6920 commercialisé par STMicroelectronics. Ce circuit nécessite néanmoins une tension plus élevée pour démarrer, qui lui sera fournie comme on le verra ci-après.

Un tel convertisseur 16 est généralement prévu pour travailler avec une tension d'entrée maximale de quelques volts, alors que la tension Vin peut atteindre la tension Vp du panneau. De préférence, on prévoit à l'entrée du convertisseur 16 un circuit limiteur de tension 17 à base de transistor et diode Zener pour maintenir la tension d'entrée du convertisseur dans les limites requises.

Le circuit de commande 14 intègre ici, comme moyen de communication avec une centrale de gestion, un modem à courant porteur relié à un transformateur de courant 18 inséré dans le conducteur de liaison série au niveau de la borne B2. Le module peut ainsi, par exemple, transmettre à la centrale de gestion la valeur de la tension fournie par le panneau 12, mesurée par un pont de résistances 20, et recevoir des commandes de commutation du transistor S.

Afin d'améliorer la transmission par courant porteur, on prévoit un condensateur C2 connecté aux bornes de l'élément diode Dn. Ce condensateur offre une faible impédance à la fréquence de modulation du courant porteur, et permet donc de court-circuiter les impédances complexes introduites par les divers éléments connectés entre les bornes B1 et B2.

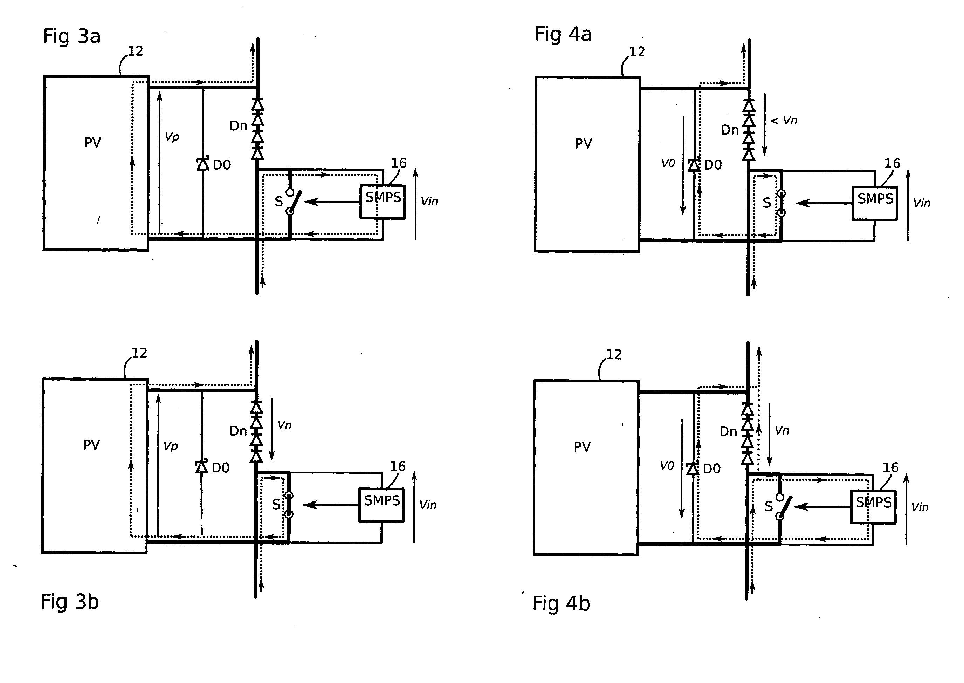

Les figures 3a et 3b représentent deux modes de fonctionnement du module de la figure 2 lorsque le panneau 12 produit de l'électricité. Le transistor S est symbolisé par un commutateur et on suppose que le circuit 14 (non représenté ici) commande la fermeture du transistor S en permanence, ce qui est équivalent, comme cela est représenté, à la commande du transistor S par la sortie du convertisseur 16. On suppose aussi que les extrémités de la chaîne de panneaux sont reliées à l'onduleur qui ferme le circuit de courant.

A la figure 3a, on se trouve dans une situation de démarrage du parc en plein jour. Le module était dépourvu d'alimentation, puisque le courant série était nul. Le transistor S est donc ouvert. La tension Vp aux bornes du panneau 12 établit un courant qui peut passer par les éléments diode Dn des autres modules (non représentés), l'onduleur (non représenté), et le convertisseur 16. Ce courant vaut :

$$I = [Vp - (n-1)Vn]/(Zinv+Zsmps),$$

et on a Vin = Zsmps·I,

où Vn est le seuil de conduction d'un élément diode Dn, n le nombre de panneaux, Zinv l'impédance de l'onduleur et Zsmps l'impédance du convertisseur 16. L'onduleur étant conçu pour traiter une puissance importante, son impédance est faible, tandis que l'impédance du convertisseur 16 est plutôt élevée. Ainsi, la tension Vin à l'entrée du convertisseur s'établit pratiquement à Vp - (n-1)Vn, ce qui est amplement suffisant pour le démarrage du convertisseur. Le transistor S est aussitôt fermé, et on se trouve dans le mode de la figure 3b.

Par contre, si l'onduleur n'est pas connecté à la chaîne, par exemple si les panneaux sont en cours d'installation, aucun courant ne peut s'établir et le transistor S reste ouvert. Cela supprime le risque d'électrocution.

A la figure 3b le transistor S s'est donc fermé. Il s'agit du mode de fonctionnement normal du parc. Le courant arrive du module précédent, passe par le transistor S et le panneau 12, et parvient au module suivant. Ainsi, la tension d'entrée Vin du convertisseur 16 est prélevée aux bornes d'un transistor S fermé.

Comme on l'a précédemment indiqué, la résistance à l'état passant du transistor S est choisie pour que la chute de tension à ses bornes soit suffisante pour alimenter le convertisseur 16, une fois que celui-ci a démarré. On souhaite que la chute de tension aux bornes du transistor soit suffisante pour alimenter le convertisseur, mais qu'elle n'affecte pas significativement le rendement de production d'énergie. Une chute de tension de l'ordre de 100 mV constituerait un bon compromis.

En fait, dans le mode de la figure 3b, la tension Vin s'avère être régulée à une valeur suffisante. En effet, si cette tension Vin devient insuffisante, le convertisseur 16 ne peut plus commander le transistor S, et ce dernier se met à moins conduire. Du coup, la tension Vin à ses bornes augmente jusqu'à ce qu'elle soit de nouveau suffisante pour alimenter le convertisseur 16.

A partir de ce mode de fonctionnement, on peut vouloir commander l'ouverture du transistor S, par exemple pour déconnecter le panneau après avoir détecté une anomalie. A l'ouverture du transistor S, le courant série se met à circuler essentiellement par l'élément diode Dn qui voit une chute de tension en inverse Vn égale au seuil de conduction de l'élément Dn. La tension d'entrée du convertisseur 16 vaut alors Vin = Vp+Vn, qui est la valeur la plus élevée parmi les modes de fonctionnement possibles.

Les figures 4a et 4b représentent deux modes de fonctionnement du module de la figure 2 lorsque le panneau 12 ne produit pas d'électricité.

La figure 4a illustre un mode de fonctionnement atteint après celui de la figure 3b. Le panneau 12 cesse de produire de l'électricité, par exemple parce qu'il se trouve à l'ombre. Le panneau passe d'un fonctionnement en générateur à un fonctionnement en charge traversée par le courant série. La tension à ses bornes s'inverse jusqu'au seuil de conduction V0 de la diode D0, qui prend alors le relais pour faire circuler le courant série.

On comprend ici que le seuil de conduction Vn de l'élément Dn est de préférence supérieur à V0, de sorte que le courant série passe préférentiellement par la diode D0, et donc par le transistor S pour alimenter le convertisseur 16, au lieu de passer par l'élément Dn sans passer par le transistor S.

La chaîne produisant moins d'énergie du fait de la défaillance d'un panneau, le courant série diminue également. Par conséquent, la tension Vin aux bornes du transistor S diminue. Le convertisseur 16 réagit de nouveau en diminuant la conductance du transistor S jusqu'à ce que la tension à ses bornes alimente suffisamment le convertisseur.

Si tous les panneaux cessent de produire de l'électricité, par exemple à l'arrivée de la nuit, le courant série devient insuffisant pour alimenter le convertisseur 16. L'impédance de celui-ci devient inférieure à celle du transistor S, et la tension Vin diminue en dessous du seuil de fonctionnement du convertisseur. Le transistor S s'ouvre, et le courant série continue à circuler par le convertisseur 16 et la diode D0.

Si on souhaite continuer à alimenter les modules à partir de cet instant, il suffit que la centrale de gestion injecte un courant série suffisant, comme cela sera décrit ci-après.

A la figure 4b, le transistor S se trouve ouvert dans une situation où le courant série est suffisant pour alimenter les modules, mais où le panneau ne produit pas d'électricité. On rencontre cette situation au démarrage du parc à l'arrivée du jour et le panneau se trouve à l'ombre ou bien est défectueux. Le module peut aussi avoir reçu une commande d'ouverture du transistor S.

Le courant série se répartit entre la diode D0, en passant par le convertisseur 16, et l'élément diode Dn. La tension Vin est alors égale à Vn-V0. Ainsi, le seuil Vn de l'élément Dn est de préférence choisi pour que la tension Vn-V0 soit supérieure à une valeur permettant le démarrage du convertisseur 16.

Dans une situation de démarrage, le module n'a pas reçu de commande pour ouvrir le transistor S. Le convertisseur ferme le transistor S dès que sa tension d'entrée Vin atteint une valeur suffisante à son démarrage. On se trouve alors dans le mode de fonctionnement de la figure 4a.

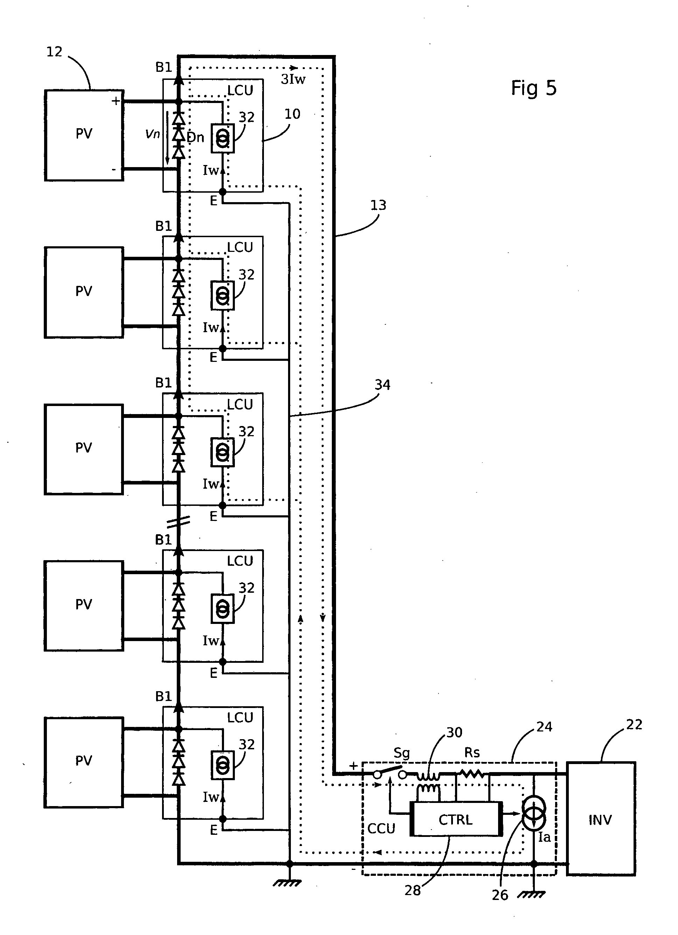

La figure 5 représente schématiquement une chaîne de panneaux solaires reliée à un onduleur 22 (INV) par les deux extrémités du conducteur série 13. L'onduleur est précédé d'une centrale de gestion 24 (CCU), mettant en oeuvre des fonctions précédemment évoquées. Dans ce mode de réalisation, la centrale comprend, en série sur le conducteur 13, un interrupteur général Sg de mise hors service du parc, et une résistance Rs de mesure du courant série. Une source de courant auxiliaire 26 est connectée pour injecter un courant série Ia dans le conducteur 13, de même sens que le courant nominal.

Un circuit de commande 28 gère les fonctions de la centrale CCU. Il commande notamment l'interrupteur Sg et la source de courant 26, et détermine le courant série en mesurant la tension aux bornes de la résistance Rs. Il comprend en outre un modem à courant porteur permettant de communiquer avec des modems homologues des modules LCU par un transformateur de courant 30 inséré dans la ligne 13.

L'interrupteur général Sg est ouvert pour effectuer des opérations de maintenance. Son ouverture annule le courant série, donc l'alimentation des modules qui voient leurs transistors S s'ouvrir, supprimant tout risque d'électrocution.

L'interrupteur général Sg est fermé en fonctionnement normal. Lorsque l'éclairement des panneaux faiblit, le courant série diminue. Le circuit de commande 28 met en service la source de courant auxiliaire 26 pour continuer à alimenter les modules LCU lorsque le courant série atteint une valeur minimale. La centrale CCU tirera son alimentation d'une batterie rechargée pendant le jour, ou bien du réseau électrique.

Les modules LCU sont ainsi alimentés de jour comme de nuit et peuvent communiquer à tout moment avec la centrale CCU par courant porteur.

Si le conducteur unique 13 est sectionné, comme cela est illustré entre les deuxième et troisième modules en partant du bas, le courant série s'annule et les modules ne sont plus alimentés. On souhaiterait néanmoins connaître l'emplacement de la coupure du conducteur. Puisque le courant série s'annule en même temps pour tous les modules, l'intelligence embarquée dans un module ne peut pas servir à localiser la coupure.

La figure 5 illustre en outre un mode de réalisation de système de localisation de coupure du conducteur série. Chaque module 10 comprend une source de courant constant 32 connectée entre le conducteur série 13, par exemple au niveau de la borne B1 du module, et une borne de terre E du module. La fonction de la borne de terre E est normalisée. Elle sert à connecter les parties métalliques du panneau à la terre par un conducteur 34 commun à tous les panneaux. Ce conducteur est en outre relié à l'entrée négative de la centrale de gestion CCU et à l'entrée négative de l'onduleur, si le fabriquant a prévu la mise à la terre de l'onduleur de cette façon. Certains onduleurs sont connectés à la terre par leur entrée positive, dans ce cas, on inverse la direction du courant des sources 32.

Chaque source 32 est prévue pour faire circuler un courant de surveillance constant Iw de la borne de terre E vers la borne B1 du module. Ainsi un courant Iw partant de chaque source 32 circule, comme cela est représenté en pointillés, dans le sens horaire en suivant le courant série dans le conducteur 13, traversant la centrale CCU, jusqu'à la connexion du conducteur 13 à la terre. Là, les courants Iw retournent vers les sources 32 respectives par le conducteur de terre 34.

Lorsque le conducteur 13 est sectionné, par exemple entre le deuxième et troisième modules en partant du bas, les sources de courant 32 des modules se trouvant sous la coupure ne peuvent plus faire circuler leur courant Iw. Par contre, les sources 32 des modules se trouvant au-dessus de la coupure peuvent, comme cela est représenté, toujours faire circuler leur courant. La somme des courants de surveillance Iw arrivant à la centrale CCU est donc représentative du rang du module au niveau duquel se situe la coupure.

Plus précisément, lors d'une coupure du conducteur série 13, le courant série s'annule. La centrale CCU le détecte et met en service la source de courant auxiliaire 26. Le courant auxiliaire Ia, destiné à alimenter les modules, a une valeur nominale supérieure à la somme des courants de surveillance. Comme dans cette situation seuls les courants de surveillance peuvent circuler par la source auxiliaire 26, ils imposent leur valeur, qui s'établit à 3·Iw dans cet exemple. Le circuit de commande 28 divise ce courant résiduel par la valeur Iw d'un courant de surveillance, et trouve ainsi le rang, 3 en partant du haut, du module au niveau duquel se trouve la coupure. Le courant résiduel est au plus égal à n·Iw (où n est le nombre de modules), ce qui correspond au cas où la coupure a lieu entre le premier module et l'onduleur. Si la coupure a lieu entre le dernier module et l'onduleur, le courant résiduel est nul.

Ce système de localisation de coupure est indépendant du type de module utilisé. Il peut s'agir d'un module sans aucune intelligence. Les sources de courant 32 seront de préférence de type bipolaire, afin qu'ils n'aient pas besoin d'alimentation électrique au niveau des modules. Une source de courant bipolaire tire son alimentation de la tension présente entre ses deux bornes, pourvu qu'elle soit suffisante.

Lorsque tous les panneaux sont alimentés et qu'il n'y a pas de coupure, les tensions aux bornes des sources 32 sont proches de la tension d'entrée de l'onduleur, à quelques seuils Vn près. Toutefois, les sources 32 se trouvent polarisées en inverse et sont de ce fait inactives.

Lorsqu'il y a une coupure, la source de courant auxiliaire 26 inverse la tension d'entrée sur l'onduleur, les sources 32 étant alors polarisées et devenant actives. La source 32 ayant la tension la plus faible à ses bornes est celle du premier module, qui voit une tension Va - (n-1)Vn, où Va est la tension aux bornes de la source de courant auxiliaire 26. La tension d'alimentation de la source auxiliaire 26 est de préférence choisie pour que la source 32 du premier module voie une tension suffisante à ses bornes.

Dans des installations de base, on peut se passer de certaines fonctions pour réduire le coût, notamment des fonctions de communication par courant porteur. On souhaite toutefois conserver des fonctions de sécurité, notamment celles supprimant le risque d'électrocution. On a vu qu'un module du type de la figure 2 assure, sans communication aucune avec la centrale, une ouverture automatique du transistor S dès qu'il n'est plus parcouru par un courant. En d'autres termes, dès que le courant série est coupé, soit par un commutateur général au niveau de l'onduleur, soit par l'enlèvement d'un panneau, les transistors S de tous les modules déconnectent les panneaux du conducteur série, supprimant ainsi le risque d'électrocution.

Toutefois, on pourrait souhaiter une fonction de sécurité plus poussée, à savoir une reconnexion des panneaux seulement sur commande explicite. En utilisant des modules du type de la figure 2, une telle fonction peut être obtenue en utilisant un circuit de commande local 14 qui attend un ordre spécifique pour fermer le transistor S. Cet ordre lui arriverait de la centrale par courant porteur.

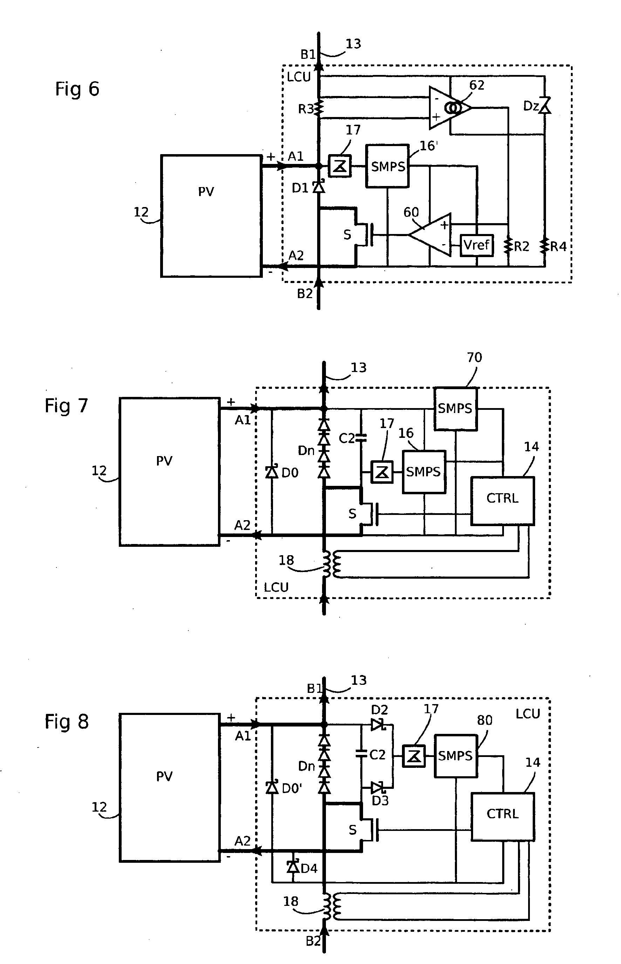

La figure 6 représente un mode de réalisation de module de commande local permettant de réaliser cette fonction sans moyens de communication complexes. Par rapport à la figure 2, on a remplacé l'élément diode Dn par une diode unique D1, de préférence de type Schottky. La diode D0 a été supprimée. Le convertisseur servant à alimenter les circuits du module, ici désigné par 16', prend sa tension d'entrée aux bornes du panneau 12, c'est-à-dire sur les bornes A1 et A2. En d'autres termes, le module n'est alimenté ici que si le panneau 12 produit de l'électricité. Comme on souhaite alimenter le module même si le panneau est faiblement éclairé, et qu'il produit une faible tension, le convertisseur 16' est de préférence de type élévateur. Ainsi, il est préférable de prévoir un limiteur de tension 17 à l'entrée du convertisseur pour adapter sa tension d'entrée lorsque le panneau produit sa tension nominale.

Le transistor S est commandé par un comparateur 60 qui compare la tension aux bornes d'une résistance R2 à une tension de référence Vref et ferme le transistor S quand la tension aux bornes de la résistance R2 dépasse la tension de référence Vref. Un amplificateur à transconductance 62 injecte dans la résistance R2 un courant indicatif du courant série dans le conducteur 13. L'amplificateur 62 mesure une tension représentative du courant série aux bornes d'une résistance R3 placée dans le conducteur 13 entre les bornes A1 et B1.

L'amplificateur 62 est alimenté aux bornes d'une diode Zener Dz dont la cathode est connectée à la borne B1 et l'anode est connectée à la borne A2 par une résistance R4.

Avec cette configuration, dès que le panneau 12 produit de l'électricité, le convertisseur 16' alimente les circuits du module. Toutefois, le transistor S reste ouvert. Il en est de même pour tous les modules de la chaîne. Les panneaux restent déconnectés du conducteur série 13, même si l'ensemble de l'installation est sous tension.

Afin de mettre en marche l'installation, la centrale de commande CCU (figure 5) injecte un courant auxiliaire dans le conducteur série 13. Ce courant passe par les diodes D1 et les résistances R3 des modules. Ce courant est choisi suffisant pour faire basculer les comparateurs 60. Les transistors S se ferment en connectant les panneaux au conducteur série. Le courant passe, dans chaque module, par le transistor S, le panneau 12, et la résistance R3. Le courant passant par la résistance R3 étant plus élevé encore que le courant auxiliaire, la fermeture du transistor S est maintenue.

Dès qu'un panneau 12 ne produit plus d'électricité, le module correspondant n'est plus alimenté, et son transistor S s'ouvre. Le courant série passe alors par la diode D1. Dès que le panneau se met de nouveau à produire de l'électricité, le module est alimenté. Le courant dans la résistance R3 étant suffisant, le comparateur 60 ferme immédiatement le transistor R3.

Afin de provoquer une nouvelle déconnexion de sécurité des panneaux, on ouvre l'interrupteur général Sg (figure 5). Une fermeture subséquente de cet interrupteur met l'installation sous tension, mais ne provoque pas la fermeture des transistors S - pour cela, il faut de nouveau injecter un courant dans le conducteur série.

Un avantage de ce mode de réalisation, par rapport à celui de la figure 2, est que les chutes de tension parasites introduites par le module peuvent être minimisées. En effet, le transistor S peut être choisi avec une résistance à l'état passant aussi faible que souhaité. La diode D1, de type Schottky, présente un seuil de conduction très bas.

La figure 7 représente une variante du module de la figure 2. Par rapport à la figure 2, le module comprend un deuxième convertisseur 70 alimenté entre les bornes A1 et A2, venant suppléer au convertisseur 16, notamment dans le mode de fonctionnement de la figure 3b.

Le mode de la figure 3b correspond à un mode normal d'un panneau produisant de l'électricité. Ce mode est celui qu'on cherche à avoir le plus longtemps possible. C'est aussi un mode où l'on voudrait utiliser le plus de fonctionnalités du module. Par contre, c'est aussi un mode où le module de la figure 2 est le moins bien alimenté (à partir de la chute de tension aux bornes du transistor S fermé). Les fonctionnalités souhaitées, mises en oeuvre par microcontrôleur, peuvent consommer plus de courant que ne peut fournir le convertisseur 16 à partir d'une tension de l'ordre de 100 mV.

Le convertisseur supplémentaire 70 permet d'alimenter le module à partir du panneau, et donc remplacer le convertisseur 16 dans les modes où le panneau produit de l'électricité. Dans les modes où le panneau ne produit pas d'électricité, c'est le convertisseur 16 qui alimente le module de la manière précédemment décrite. Le convertisseur 70 est de préférence un abaisseur de tension.

La figure 8 représente une variante du module de la figure 7. Par rapport à la figure 7, les deux convertisseurs 16 et 70 sont remplacés par un unique convertisseur 80, de type élévateur. L'entrée positive du convertisseur 80 est reliée à la borne A1 par une diode D2 et à la borne B2 par une diode D3. Ces diodes sont connectées pour fournir au convertisseur 80 le plus élevé des potentiels présents sur les bornes A1 et B2.

La diode D0 est remplacée par une diode D0' dont la cathode reste connectée à la borne A1, mais dont l'anode n'est plus connectée à la borne A2. L'anode de la diode D0' est connectée à la borne négative du convertisseur 80. Une diode D4 est reliée par sa cathode à la borne A2 et par son anode à la borne négative du convertisseur 80.

Le convertisseur 80 est de type élévateur pour travailler avec une tension d'entrée maximale de quelques volts. Toutefois, cette tension d'entrée peut, par les diodes D2 ou D3, selon le mode de fonctionnement, atteindre la tension du panneau, ce qui peut être incompatible avec la plage de fonctionnement du convertisseur. De préférence, comme pour la figure 2, on prévoit à l'entrée du convertisseur un circuit limiteur de tension 17 qui ramène la tension d'entrée à une valeur acceptable lorsque le convertisseur est alimenté par le panneau.

Les diodes D0' et D2 à D4 sont, de préférence, des diodes à faible seuil de conduction, par exemple de type Schottky.

Cette variante, comme on le verra ci-après, permet au convertisseur 80 de travailler dans de meilleures conditions que dans les figures 2 et 7, dans les modes où le panneau ne produit pas d'électricité.

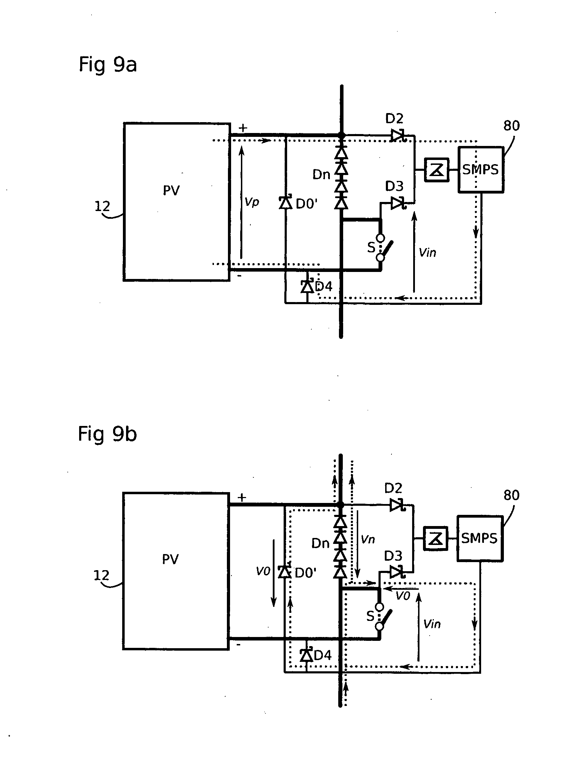

La figure 9a illustre le module de la figure 8 dans un mode de fonctionnement où le panneau 12 produit de l'électricité. Une partie du courant du panneau passe par la diode D2, le convertisseur 80, la diode D4, et retourne dans le panneau. Quel que soit l'état du transistor S, celui-ci n'est pas parcouru par le courant qui alimente le convertisseur. S'il est ouvert, le courant série passe par l'élément diode Dn. S'il est fermé, le courant série passe par le transistor et par le panneau.

Le convertisseur est ainsi alimenté par une tension Vin = Vp - 2V0.

La figure 9b illustre le module de la figure 8 dans un mode de fonctionnement où le panneau 12 ne produit pas d'électricité. Une partie du courant série passe par l'élément diode Dn, qui voit à ses bornes une tension seuil Vn en inverse. Cette tension Vn alimente le convertisseur 80 : une deuxième partie du courant série passe par la diode D3, le convertisseur 80, et la diode D0'. Le transistor S, qu'il soit fermé ou ouvert, n'affecte pas le courant qui alimente le convertisseur 80.

Le convertisseur est ainsi alimenté par une tension Vin = Vn - 2V0. En fonction du courant consommé par les circuits du module, on choisira la tension seuil Vn de l'élément diode Dn pour que le convertisseur puisse fournir la puissance requise.

Un module du type de la figure 7 ou 8 reste alimenté même s'il est déconnecté du conducteur série 13, tant que son panneau est éclairé. De ce fait, l'ouverture du transistor S n'est pas automatique à la déconnexion du module. Si l'on souhaite limiter le risque d'électrocution dans les modules des figures 7 et 8, on pourra prévoir le même mécanisme que celui de la figure 6.

Selon une alternative utilisant la communication par courant porteur, le module et la centrale 24 sont configurés pour mettre en oeuvre une procédure de « chien de garde » ou « watch-dog ». La centrale émet périodiquement un signal de vérification. A chaque réception du signal de vérification, le module réinitialise un compteur de temps. Si le signal de vérification n'est plus reçu, parce que le module a été déconnecté du conducteur série 13, le compteur arrive à expiration et le module commande l'ouverture du transistor S. Dès que le module reçoit de nouveau le signal de vérification, il commande la fermeture du transistor S.

## Revendications

1. Module de commande locale d'un panneau photovoltaïque comprenant :

  - des première et seconde bornes (B1, B2) de mise en série par un conducteur unique (13) avec des modules homologues ;
  - une première borne (A1) de connexion du panneau photovoltaïque, reliée à la première borne (B1) de mise en série ;

  - un commutateur (S) relié entre la seconde borne (B2) de mise en série et une seconde borne (A2) de connexion du panneau ;
  - une diode (DO) reliée entre les première et seconde bornes (B1, B2) de mise en série ; et
  - un convertisseur (70) prévu pour alimenter le module à partir de la tension développée par le panneau entre les première et seconde bornes (A1, A2) de connexion du panneau ;
  **caractérisé en ce qu'**il comprend : .
  - un capteur (R3) pour mesurer le courant circulant dans le conducteur unique (13) ; et
  - des moyens (60, 62) pour fermer le commutateur lorsque le courant circulant dans le conducteur unique dépasse un seuil.

2. Module selon la revendication 1, **caractérisé en ce que** le commutateur (S) est ouvert en absence d'alimentation électrique, d'où il résulte que le commutateur s'ouvre et reste ouvert lorsque le panneau photovoltaïque fournit une tension insuffisante pour alimenter le module.

3. Centrale de gestion d'un ensemble de modules selon la revendication 1 reliés en série par un conducteur unique (13), **caractérisée en ce qu'**elle comprend :

  - des moyens (28) pour déterminer une mise sous tension de l'ensemble des modules ; et
  - des moyens (26) pour injecter dans le conducteur unique un courant supérieur audit seuil lorsque la mise sous tension est déterminée, d'où il résulte la fermeture des commutateurs (S) des modules associés à des panneaux fournissant de l'électricité.

## Patentansprüche

1. Lokales Steuermodul für ein Solarpaneel, umfassend:

  - einen ersten und einen zweiten Anschluss (B1, B2) für eine Reihenschaltung mit entsprechenden Modulen über einen einzigen Leiter (13);
  - einen ersten Anschluss (A1) zur Verbindung des Solarpaneels, der mit dem ersten Anschluss (B1) für die Reihenschaltung verbunden ist;
  - einen Schalter (S), der zwischen dem zweiten Anschluss (B2) für die Reihenschaltung und einem zweiten Anschluss (A2) zur Verbindung des Paneels liegt;
  - eine Diode (D0), die zwischen den ersten und den zweiten Anschluss (B1, B2) für die Reihenschaltung geschaltet ist; und
  - einen Wandler (70), der vorgesehen ist, um das Modul aus der Spannung zu versorgen, die von dem Paneel zwischen dem ersten und dem zweiten Anschluss (A1, A2) zur Verbindung des Paneels erzeugt wird;

**dadurch gekennzeichnet, dass** es umfasst:

- einen Sensor (R3) zum Messen des in dem einzigen Leiter (13) fließenden Stroms; und
- Mittel (60, 62) zum Schließen des Schalters, wenn der in dem einzigen Leiter fließende Strom eine Schwelle überschreitet.

2. Modul nach Anspruch 1, **dadurch gekennzeichnet, dass** der Schalter (S) in Abwesenheit einer elektrischen Versorgung geöffnet ist, woraus folgt, dass der Schalter sich öffnet und offen bleibt, wenn das Solarpaneel eine unzureichende Spannung zum Versorgen des Moduls liefert.

3. Zentrale Steuereinrichtung einer Anordnung aus Modulen nach Anspruch 1, die über einen einzigen Leiter (13) in Reihe geschaltet sind, **dadurch gekennzeichnet, dass** sie umfasst:

- Mittel (28) zum Bestimmen einer Spannungszuschaltung der Anordnung von Modulen; und
- Mittel (26) zum Zuführen eines in Bezug auf die Schwelle höheren Stroms in den einzigen Leiter, wenn die Spannungszuschaltung bestimmt wird, wodurch das Schließen der Schalter (S) der Module, die den den Strom liefernden Paneelen zugeordnet sind, resultiert.

**Claims**

1. A module is provided for locally controlling a photovoltaic panel that includes:

- a first terminal and a second terminal (B1, B2) for connecting in series the module to homologous modules by a single conductor (13);
- a first terminal (A1) for connecting the photovoltaic panel, said first terminal (A1) being connected to the first terminal (B1) for connecting in series the module;
- a switch (S) connected between the second terminal (B2) for connecting in series the module and a second terminal (A2) for connecting the panel;
- a diode (D0) connected between the first and second terminals (B1, B2) for connecting in series; and
- a converter (70) provided for power supplying the module from the voltage delivered by the panel between the first and second terminals (A1, A2) connecting the panel;

**characterized in that** the module includes:
- a sensor (R3) for measuring the current flowing through the single conductor (13); and

- means (60, 62) for closing the switch when the current flowing within the single conductor exceeds a threshold.

2. The module according to claim 1, **characterized in that** the switch (S) is open in the absence of power supply, so that the switch opens and remains open when the photovoltaic panel provides an insufficient voltage to power the module.

3. A central control unit for controlling a set of modules according to claim 1 connected in a series by a single conductor (13), **characterized in that** it comprises :

- means (28) for determining a power-on of the set of modules; and
- means (26) for injecting into the single conductor a current that is above the threshold when the power-on is determined, resulting in closing the switches (S) of the modules associated with panels supplying electricity.

Fig 1

Fig 2

Fig 4a

Fig 4b

Fig 3a

Fig 3b

Fig 5

Fig 6

Fig 7

Fig 8

Fig 9a

Fig 9b

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 0180321 A
- EP 2141746 A2
- US 7602080 B